Europäisches Patentamt

European Patent Office

Office européen des brevets

(11) Veröffentlichungsnummer: **0 255 909 B1**

# EUROPÄISCHE PATENTSCHRIFT

(45) Veröffentlichungstag der Patentschrift: **15.04.92**

(51) Int. Cl.⁵: **G01R 1/073**, G01R 31/28

(21) Anmeldenummer: **87110885.8**

(22) Anmeldetag: **27.07.87**

(54) **Prüfeinrichtung für beidseitige Kontaktierung bestückter Leiterplatten.**

(30) Priorität: **07.08.86 DE 3626693**

(43) Veröffentlichungstag der Anmeldung:
**17.02.88 Patentblatt 88/07**

(45) Bekanntmachung des Hinweises auf die
Patenterteilung:
**15.04.92 Patentblatt 92/16**

(84) Benannte Vertragsstaaten:
**BE DE FR GB IT SE**

(56) Entgegenhaltungen:
**DE-B- 2 657 910**
**US-A- 4 099 120**
**US-A- 4 115 735**

**IEEE INSTRUMENTATION AND MEASURE-
MENT CONFERENCE, Boulder, Colorado, US,
25.-27. März 1986, Seiten 31-38, IEEE; M. BUL-
LOCK et al.: "The impact of surface mount
devices on in-circuit testing"**

(73) Patentinhaber: **SIEMENS AKTIENGESELL-
SCHAFT**
**Wittelsbacherplatz 2**
**W-8000 München 2(DE)**

(72) Erfinder: **Hilz, Wolfgang**
**Schulstrasse 43**
**W-8000 München 19(DE)**
Erfinder: **Schuster, Rudolf, Dipl.-Ing.**
**Graf-Andechs-Strasse 8**
**W-8011 Heimstetten(DE)**
Erfinder: **Schauflinger, Hans**
**Mauthäuslstrasse 39**
**W-8000 München 70(DE)**

## Beschreibung

Die Erfindung betrifft eine Prüfeinrichtung für bestückte Leiterplatten, mit einem unteren Nadeladapter, der prüflingsspezifisch angeordnete, gefederte untere Kontaktnadeln zur Kontaktierung der Unterseite der Leiterplatte trägt, und mit mehreren, prüflingsspezifisch angeordneten oberen Andruckstößeln.

Für die elektrische Prüfung bestückter Leiterplatten, die auch als Flachbaugruppen bezeichnet werden können, sind Nadeladapter mit prüflingsspezifisch angeordneten Kontaktstiften im Einsatz. Man unterscheidet dabei zwischen Schaltkreistest oder Funktions- bzw. Teilfunktionstest. Bei der Prüfung wird die bestückte Leiterplatte mit der Lötseite gegen im Nadeladapter angeordnete, gefederte Kontaktnadeln gedrückt. Soll nun in derselben Prüfeinrichtung sowohl ein Schaltkreistest als auch ein Funktions- bzw. Teilfunktionstest durchgeführt werden, so ist eine zweistufige Kontaktierung mit unterschiedlich langen Kontaktnadeln vorzusehen. In der ersten Stufe der Kontaktierung kommen beim Funktions- bzw. Teilfunktionstest dann nur die langen Kontaktnadeln zum Eingriff, während in der zweiten Stufe der Kontaktierung beim Schaltkreistest die kurzen Kontaktnadeln hinzutreten.

Im Zuge der sich immer mehr durchsetzenden SMD-Technologie wird jedoch die Forderung nach einer zweiseitigem Kontaktierung immer mehr erhoben werden (siehe z.B.:US-A-4 099 120). Außerdem lassen sich Steckeranschlüsse häufig nur von oben kontaktieren, sofern man beim Funktionstest auf das aufwendige seitliche Ankontaktieren der Stecker verzichten will.

Das zur Kontaktierung erforderliche Andrücken der bestückten Leiterplatten kann über entsprechend verteilte Andruckstößel mechanisch vorgenommen werden. Häufiger im Einsatz sind jedoch sogenannte Vakuumadapter, bei denen die bestückte Leiterplatte manuell auf ein Dichtgummi gelegt und durch Erzeugung eines Vakuums angedrückt wird. Bei derartigen Vakuumadaptern stehen dem Vorteil einer besseren Zugänglichkeit an der Bauteileseite gleich mehrere Nachteile gegenüber. Da eine optimale Dosierung des Vakuums nicht möglich ist, können durch den hohen Flächendruck auftretende unzulässig hohe Durchbiegungen der Leiterplatten nicht sicher vermieden werden. Außerdem stellt die Abdichtung ein erhebliches Problem dar, so daß eine sichere Kontaktierung häufig nur durch Nachdrücken an bestimmten Stellen oder andere zusätzlich manuelle Eingriffe gewährleistet werden kann. Weiterhin ist das Spektrum der für die Prüfung in Vakuumadaptern geeigneten Leiterplatten begrenzt, da beispielsweise keine offenen Durchkontaktierungen und Durchbrüche vorhanden sein sollen. Im Hinblick auf eine Automatisierung der Endprüfung bestückter Leiterplatten treten die vorstehend genannten Probleme noch stärker hervor. Insbesondere die Kontaktiersicherheit würde durch zusätzlich auftretende Dichtprobleme bei einem automatischen Wechsel der Leiterplatten weiter herabgesetzt.

Der Erfindung liegt die Aufgabe zugrunde, eine Prüfeinrichtung für die beidseitige Kontaktierung bestücker Leiterplatten zu schaffen, bei welcher in jeder Kontaktierstufe eine eindeutig definierte und zuverlässige Fixierung der Leiterplatte und eine hohe Kontaktiersicherheit gewährleistet ist.

Diese Aufgabe wird bei einer Prüfeinrichtung der eingangs genannten Art erfindungsgemäß dadurch gelöst, daß zusätzlich ein oberer Nadeladapter vorgesehen ist, der prüflingsspezifisch angeordnete, gefederte obere Kontaktnadeln trägt und daß zusätzlich mehrere, prüflingsspezifisch angeordnete untere Andruckstößel vorgesehen sind, wobei die Leiterplatte mit federnd ausgebildeten Andruckstößeln gegen gegenüberliegende, unnachgiebig angeordnete Andruckstößel drückbar ist.

Die erfindungsgemäße Prüfeinrichtung ermöglicht somit eine beidseitige Kontaktierung bestückter Leiterplatten, die durch die mechanische Einspannung der Leiterplatten zwischen oberen und unteren Andruckstößeln ermöglicht wird.

Eine wesentliche Voraussetzung für eine hohe Kontaktiersicherheit ist dabei die Kombination von fest angeordneten und federnd ausgebildeten Andruckstößeln. So wird bei der Kontaktierung einer ersten Plattenseite die Leiterplatte durch die federnden Andruckstößel gegen die gegenüberliegenden Kontaktnadeln und gegen die gegenüberliegenden fest angeordneten Andruckstößel gedrückt, wobei letztere quasi als Anschlag wirken und einen eindeutig definierten Kontaktierzustand gewährleisten. Anschließend geben die federnden Andruckstößel weiter nach, bis auch auf der gegenüberliegenden Plattenseite eine Kontaktierung mit eindeutig definiertem Kontaktierzustand erreicht ist.

In der Praxis hat es sich für die Durchführung der Prüfung als besonders günstig herausgestellt, wenn die oberen Andruckstößel federnd ausgebildet sind und die unteren Andruckstößel unnachgiebig angeordnet sind.

Weiterhin ist es im Hinblick auf eine möglichst einfache Realisierung der Prüfeinrichtung zweckmäßig, wenn der untere Nadeladapter ortsfest angeordnet ist und der obere Nadeladapter in vertikaler Richtung verstellbar angeordnet ist. In diesem Fall können dann die federnden oberen Andruckstößel fest im oberen Nadeladapter angeordnet werden. Der obere Nadeladapter und die oberen Andruckstößel können somit über einen gemeinsamen Antrieb bewegt werden.

Gemäß einer besonders bevorzugten Ausgestaltung der Erfindung ist vorgesehen, daß der untere Nadeladapter prüflingsspezifisch angeordnete und zur zweistufigen Kontaktierung der Unterseiten der Leiterplatten unterschiedlich lange, erste und zweite gefederte untere Kontaktnadeln trägt und daß die unteren Andruckstößel in vertikaler Richtung in zwei Stufen verstellbar sind. Diese zweistufige Verstellbarkeit ermöglicht dabei eine zweistufige Kontaktierung der Unterseite mit eindeutig definierten Kontaktierzuständen.

Die unteren Andruckstößel sind vorzugsweise im unteren Nadeladapter geführt und über eine untere gemeinsame Druckplatte betätigbar. Bei einem prüflingsspezifischen Austausch des unteren Nadeladapters mit den unteren Andruckstößeln können dann die Druckplatte und deren Antrieb stets in der Prüfeinrichtung verbleiben.

Um eine beidseitig zweistufige Kontaktierung bestückter Leiterplatten realisieren zu können ist es auch möglich, daß der obere Nadeladapter prüflingsspezifisch angeordnete und zur zweistufigen Kontaktierung der Oberseiten der Leiterplatten unterschiedlich lange, dritte und vierte gefederte obere Kontaktnadeln trägt.

Eine genaue und besonders einfache Positionierung der Leiterplatten wird schließlich dadurch erreicht, daß im oberen Nadeladapter mindestens zwei den oberen Andruckstößeln vorauseilende Zentrierstifte angeordnet sind.

Ausführungsbeispiele der Erfindung sind in der Zeichnung dargestellt und werden im folgenden näher beschrieben.

Es zeigen:

Figur 1 das Kontaktierprinzip einer beidseitig einstufigen Kontaktierung bestückter Leiterplatten,

Figur 2 das Kontaktierprinzip einer beidseitig zweistufigen Kontaktierung bestückter Leiterplatten und

Figur 3 eine zur Realisierung des in Figur 2 aufgezeigten Kontaktierprinzips geeignete Prüfeinrichtung in stark vereinfachter schematischer Darstellung.

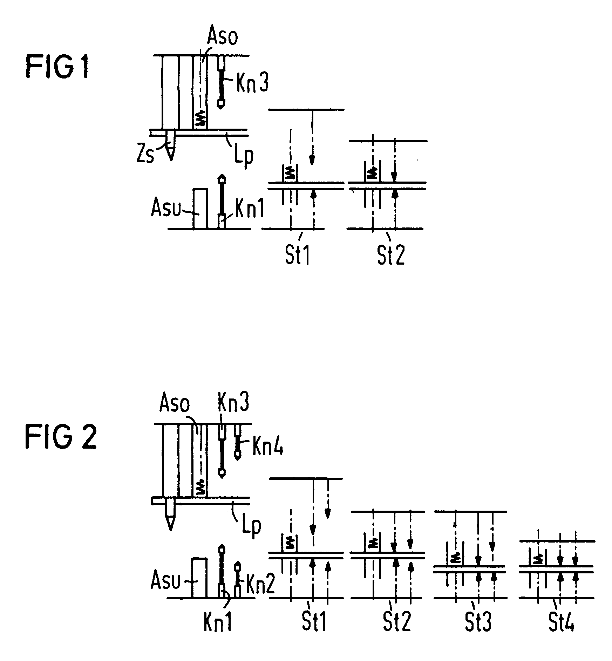

Einander entsprechende Teile sind in den Figuren 1 bis 3 mit den gleichen Bezugszeichen gekennzeichnet.

Figur 1 zeigt die Reihenfolge einer beidseitig einstufigen Kontaktierung einer Leiterplatte Lp. Auf der linken Seite der Figur 1 sind dabei in stark vereinfachter schematischer Darstellung ein unterer ortsfest angeordneter Andruckstößel Asu, eine untere Kontaktnadel Kn1, ein Zentrierstift Zs, ein oberer federnd ausgebildeter Andruckstößel Aso und eine obere Kontaktnadel Kn3 aufgezeigt. Es ist dabei eine Stellung im Anfangsstadium des Kontaktierhubes dargestellt, in welcher der Zentrierstift Zs in die zugeordnete Zentrierbohrung der Leiterplatte Lp eingedrungen ist und auch der gefederte obere Andruckstößel Aso bereits an der Leiterplatte Lp anliegt. Rechts von dieser Darstellung sind mit den hier nur noch durch Pfeile angedeuteten Kontaktnadeln die beiden aufeinanderfolgenden Kontaktierstufen St1 und St2 aufgezeigt.

In der ersten Kontaktierstufe St1 erfolgt die Kontaktierung der Unterseite der Leiterplatte Lp durch die untere Kontaktnadel Kn1. Der untere Andruckstößel Asu wirkt hier praktisch als Anschlag, der den Abwärtshub der Leiterplatte Lp begrenzt. Die Leiterplatte Lp ist dabei fest zwischen den unteren Andruckstößel Asu und den oberen Andruckstößel Aso eingespannt, d.h. der Kontaktierzustand der Kontaktierstufe St1 ist eindeutig definiert.

In der zweiten Kontaktierstufe St2 haben die oberen Andruckstößel Aso so weit federnd nachgegeben, daß nun auch eine sichere Kontaktierung der Oberseite der Leiterplatte Lp durch die oberen Kontaktnadeln Kn3 vorliegt.

Figur 2 zeigt die Reihenfolge einer beidseitig zweistufigen Kontaktierung einer Leiterplatte Lp. Auf der linken Seite der Figur 2 sind die bereits in Figur 1 dargestellten Teile und eine zusätzlich neben der ersten unteren Kontaktnadel Kn1 angeordnete, kürzere zweite untere Kontaktnadel Kn2 sowie eine zusätzlich neben der oberen dritten Kontaktnadel Kn3 angeordnete, ebenfalls kürzere obere vierte Kontaktnadel Kn4 aufgezeigt. Rechts von dieser Darstellung sind mit den nur noch durch Pfeile angedeuteten Kontaktnadeln die vier aufeinanderfolgenden Kontaktierstufen St1, St2, St3 und St4 aufgezeigt.

Auf die beiden ersten Kontaktierstufen St1 und St2 braucht nicht näher eingegangen zu werden, da sie den bereits im Zusammenhang mit Figur 1 erläuterten Kontaktierstufen St1 und St2 entsprechen.

In der dritten Kontaktierstufe St3 nimmt der untere Andruckstößel Asu eine gegenüber den Kontaktierstufen St1 und St2 tiefere Lage ein. Durch diese untere Lage des unteren Andruckstößels Asu ist nunmehr eine sichere Kontaktierung der Plattenunterseite durch die zweiten Kontaktnadeln Kn2 gewährleistet.

In der vierten Kontaktierstufe St4 ist schließlich durch weiteres federndes Nachgeben des oberen Andruckstößels Aso eine Kontaktierung der Plattenoberseite durch die vierten Kontaktnadeln Kn4 eingetreten.

Es ist zu erkennen, daß in sämtlichen Kontaktierstufen St1 bis St4 durch eine feste Einspannung der Leiterplatte Lp zwischen den unteren Andruckstößeln Asu und den oberen Andruckstößeln Aso jeweils eindeutig definierte Kontaktierzustände gewährleistet sind. Es ist ferner zu erkennen, daß für die Reihenfolge der Kontaktierungen etliche Variationen möglich sind.

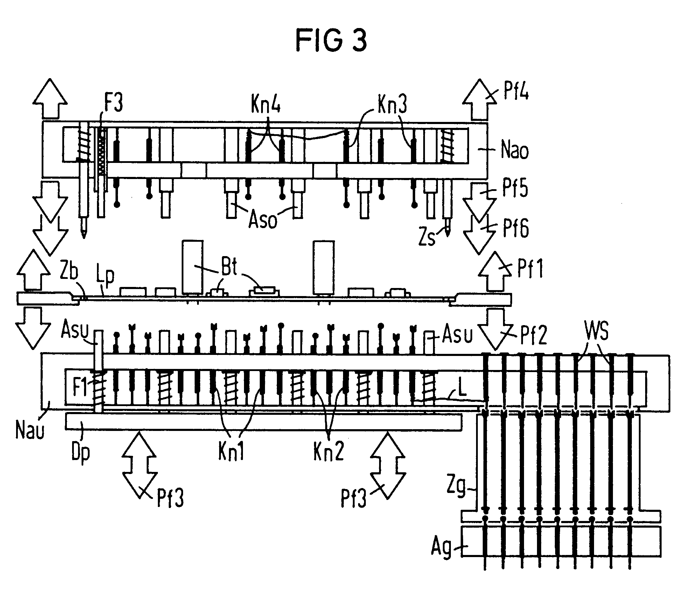

Figur 3 zeigt eine Prüfeinrichtung für beidseitige zweistufige Kontaktierung bestückter Leiterplatten in stark vereinfachter schematischer Darstellung. Mit der in Figur 3 dargestellten Prüfeinrichtung kann somit das in Figur 2 aufgezeigte Kontaktierprinzip realisiert werden.

Gemäß Figur 3 ist die zu prüfende Leiterplatte Lp mit Bauteilen Bt bestückt und in einen äußeren Rahmen eingelegt. Pfeile Pf1 und Pf2 zeigen an, daß der Rahmen in vertikaler Richtung nach oben und nach unten beweglich ist, wobei diese Beweglichkeit des Rahmens und der darin angeordneten Leiterplatte Lp beispielsweise durch eine federnde Aufhängung des Rahmens realisiert werden kann.

Unterhalb der Leiterplatte Lp befindet sich ein ortsfest angeordneter unterer Nadeladapter Nau, der erste gefederte Kontaktnadeln Kn1 und etwas kürzere zweite gefederte Kontaktnadeln Kn2 trägt. An einer Stelle ist angedeutet, daß die Kontaktnadeln Kn1 und Kn2 über Leitungen L mit zugeordneten Wrap-Stacheln WS verbunden sind. Die außerhalb des Kontaktierungsbereichs im unteren Nadeladapter Nau angeordneten Wrap-Stachel WS sind ihrerseits über ein Zwischenglied Zg mit nicht näher bezeichneten federnden Nadeln mit den ebenfalls nicht näher bezeichneten Nadeln eines Anschlußgliedes Ag verbunden. Dieses Anschlußglied Ag ist Teil des eigentlichen Prüfautomaten, bei welchem es sich beispielsweise um die "Series 700" der Firma Factron-Schlumberger, Albert Schweitzer Str. 66, D- 8000 München 83, handeln kann.

Im unteren Nadeladapter Nau sind ferner mit Asu bezeichnete untere Andruckstößel geführt, die über Federn F1 in vertikaler Richtung beweglich im Nadeladapter Nau gehalten sind. Die unteren Andruckstößel Asu sind also nicht federnd ausgebildet, sondern über eine gemeinsame untere Druckplatte Dp in vertikaler Richtung in zwei Stufen verstellbar. Diese durch Doppelpfeile Pf3 aufgezeigte zweistufige Verstellbarkeit kann beispielsweise durch unter der Druckplatte Dp angeordnete pneumatisch oder hydraulisch betätigbare Verstellzylinder realisiert werden.

Über der Leiterplatte Lp befindet sich ein in vertikaler Richtung verstellbar angeordneter oberer Nadeladapter Nao, der dritte gefederte Kontaktnadeln Kn3 und etwas kürzere vierte gefederte Kontaktnadeln Kn4 trägt. Die nicht näher dargestellte Weiterverdrahtung der Kontaktnadeln Kn3 und Kn4 umfaßt Übergabekontakte zum unteren Nadeladapter Nau, so daß die zahlenmäßig meist nur wenigen oberen Prüfkontakte ebenfalls über die Schnittstelle des Zwischengliedes Zg an den Prüfautomaten angeschlossen sind.

Im oberen Nadeladapter Nao sind mit Aso bezeichnete obere Andruckstößel fest angeordnet. Diese oberen Andruckstößel Aso sind teleskopartig federnd ausgebildet, wobei diese federnde Ausgestaltung an einer Stelle durch eine entsprechende Feder F3 aufgezeigt ist. Zwei ebenfalls im oberen Nadeladapter Nao angeordnete Zentrierstifte Zs haben die Aufgabe, in zugeordnete Zentrierbohrungen der Leiterplatte Lp einzudringen und damit die Leiterplatte Lp genau zu positionieren.

Die vertikale Verstellbarkeit des oberen Nadeladapters Nao ist durch Pfeile Pf4, Pf5 und Pf6 aufgezeigt, wobei die beiden nach unten gerichteten Pfeile Pf5 und Pf6 die Zweistufigkeit der Kontaktierung symbolisieren sollen. Die vertikale Verstellung kann beispielsweise dadurch realisiert werden, daß der obere Nadeladapter Nao in einem massiven Vier-Säulengestell geführt und je nach Adaptergröße durch ein bis vier mittels Zahnriemen synchronisierte Spindeln über einen Gleichstrommotor angetrieben wird. Der geschilderte Antrieb der Andruckmechanik ist dabei als programmierbare Positionierachse ausgeführt.

**Patentansprüche**

1. Prüfeinrichtung für bestückte Leiterplatten (Lp), mit einem unteren Nadeladapter (Nau), der prüflingsspezifisch angeordnete, gefederte untere Kontaktnadeln (Kn1, Kn2) zur Kontaktierung der Unterseite der Leiterplatte (Lp) trägt, und mit mehreren, prüflingsspezifisch angeordneten oberen Andruckstößeln (Aso),
**dadurch gekennzeichnet,**
daß zusätzlich ein oberer Nadeladapter (Nao) vorgesehen ist, der prüflingsspezifisch angeordnete, gefederte obere Kontaktnadeln (Kn3, Kn4) trägt und daß zusätzlich mehrere, prüflingsspezifisch angeordnete untere Andruckstößel (Asu) vorgesehen sind, wobei die Leiterplatte (Lp) mit federnd ausgebildeten Andruckstößeln (Aso oder Asu) gegen gegenüberliegende, unnachgiebig angeordnete Andruckstößel (Asu oder Aso) drückbar ist.

2. Prüfeinrichtung nach Anspruch 1,
**dadurch gekennzeichnet,**
daß die oberen Andruckstößel (Aso) federnd ausgebildet sind und daß die unteren Andruckstößel (Asu) unnachgiebig angeordnet sind.

3. Prüfeinrichtung nach Anspruch 1 oder 2,
**dadurch gekennzeichnet,**
daß der untere Nadeladapter (Nau) ortsfest angeordnet ist und daß der obere Nadeladapter (Nao) in vertikaler Richtung verstellbar angeordnet ist.

4. Prüfeinrichtung nach den Ansprüchen 2 und 3,
**dadurch gekennzeichnet,**
daß die oberen federnden Andruckstößel (Aso) fest im oberen Nadeladapter (Nao) angeordnet sind.

5. Prüfeinrichtung nach einem der vorhergehenden Ansprüche,
**dadurch gekennzeichnet,**
daß der untere Nadeladapter (Nau) prüflingsspezifisch angeordnete und zur zweistufigen Kontaktierung der Unterseiten der Leiterplatten (Lp) unterschiedlich lange, erste und zweite gefederte untere Kontaktnadeln (Kn1, Kn2) trägt und daß die unteren Andruckstößel (Asu) in vertikaler Richtung in zwei Stufen verstellbar sind.

6. Prüfeinrichtung nach Anspruch 5,
**dadurch gekennzeichnet,**
daß die unteren Andruckstößel (Asu) im unteren Nadeladapter (Nau) geführt und über eine untere gemeinsame Druckplatte (Dp) betätigbar sind.

7. Prüfeinrichtung nach einem der vorhergehenden Ansprüche,
**dadurch gekennzeichnet,**
daß der obere Nadeladapter (Nao) prüflingsspezifisch angeordnete und zur zweistufigen Kontaktierung der Oberseiten der Leiterplatten (Lp) unterschiedlich lange, dritte und vierte gefederte obere Kontaktnadeln (Kn3, Kn4) trägt.

8. Prüfeinrichtung nach einem der vorhergehenden Ansprüche,
**dadurch gekennzeichnet,**
daß zur Positionierung der Leiterplatten (Lp) im oberen Nadeladapter (Nao) mindestens zwei den oberen Andruckstößeln (Aso) vorauseilende Zentrierstifte (Zs) angeordnet sind.

## Claims

1. Test device for furnished printed-circuit boards (Lp), having a lower needle adapter (Nau), which carries sprung lower contact needles (Kn1, Kn2), arranged specifically for the item under test, for making contact with the lower side of the printed-circuit board (Lp), and having a plurality of upper pressure rams (Aso), arranged specifically for the item under test, characterised in that an upper needle adapter (Nao) is additionally provided, which carries sprung upper contact needles (Kn3, Kn4), arranged specifically for the item under test, and in that a plurality of lower pressure rams (Asu) are additionally provided, arranged specifically for the item under test, the printed-circuit board (Lp) being capable of being pressed by means of pressure rams (Aso or Asu), of sprung design, against opposite, non-resiliently arranged pressure rams (Asu or Aso).

2. Test device according to Claim 1, characterised in that the upper pressure rams (Aso) are of sprung design, and in that the lower pressure rams (Asu) are arranged non-resiliently.

3. Test device according to Claim 1 or 2, characterised in that the lower needle adapter (Nau) is arranged in a fixed position, and in that the upper needle adapter (Nao) is arranged such that it can be adjusted in the vertical direction.

4. Test device according to Claims 2 and 3, characterised in that the upper sprung pressure rams (Aso) are arranged fixedly in the upper needle adapter (Nao).

5. Test device according to one of the preceding claims, characterised in that the lower needle adapter (Nau) carries first and second sprung lower contact needles (Kn1, Kn2), arranged specifically for the item under test and are of different length for making a two-stage contact with the lower sides of the printed-circuit boards (Lp), and in that the lower pressure rams (Asu) are adjustable in two stages in the vertical direction.

6. Test device according to Claim 5, characterised in that the lower pressure rams (Asu) are guided in the lower needle adapter (Nau) and can be operated via a lower common pressure plate (Dp).

7. Test device according to one of the preceding claims, characterised in that the upper needle adapter (Nao) carries third and fourth sprung upper contact needles (Kn3, Kn4) arranged specifically for the item under test and are of different length for making a two-stage contact with the upper sides of the printed-circuit boards (Lp).

8. Test device according to one of the preceding claims, characterised in that at least two centring pins (Zs), projecting ahead of the upper pressure rams (Aso), are arranged in the upper needle adapter (Nao), for positioning the printed-circuit boards (Lp).

## Revendications

1. Dispositif de test pour des plaquettes à circuits imprimés équipées (Lp), comportant un adaptateur inférieur à aiguilles (Nau), qui porte des aiguilles inférieures de contact (Kn1, Kn2), qui sont disposées spécifiquement en fonction de l'échantillon et sont suspendues élastiquement et sont destinés à venir en contact avec la face inférieure de la plaquette à circuits imprimés (Lp), et plusieurs poussoirs supérieurs de serrage (Aso) disposés spécifiquement en fonction de l'échantillon, caractérisé par le fait qu'il est en outre prévu un adaptateur supérieur à aiguilles (Nao), qui porte des aiguilles supérieures de contact (Kn3, Kn4) disposées spécifiquement en fonction de l'échantillon et suspendues élastiquement, et qu'il est en outre prévu plusieurs poussoirs inférieurs de serrage (Asu) disposés spécifiquement en fonction de l'échantillon, la plaquette à circuits imprimés (Lp) pouvant être repoussée par des poussoirs de serrage agencés de manière à être élastiques (Aso ou Asu) contre des poussoirs opposés de serrage (Asu ou Aso) montés de manière à ne pas fléchir.

2. Dispositif de serrage suivant la revendication 1, caractérisé par le fait que les poussoirs supérieurs de serrage (Aso) sont agencés de manière à être élastiques et que les poussoirs inférieurs de serrage (Asu) sont montés de manière à ne pas pouvoir fléchir.

3. Dispositif de serrage suivant la revendication 1 ou 2, caractérisé par le fait que l'adaptateur inférieur à aiguilles (Nau) est monté fixe et que l'adaptateur supérieur à aiguilles (Nao) est monté de manière à être déplaçable dans la direction verticale.

4. Dispositif de test suivant les revendications 2 et 3, caractérisé par le fait que les poussoirs élastiques de serrage (Asu) sont montés de façon fixe dans l'adaptateur supérieur à aiguilles (Nao).

5. Dispositif de test suivant l'une des revendications précédentes, caractérisé par le fait que l'adaptateur inférieur à aiguilles (Nau) porte des premières et secondes aiguilles inférieures de contact (Kn1, Kn2) suspendues élastiquement, qui sont disposées spécifiquement en fonction de l'échantillon et possèdent des longueurs différentes de manière à réaliser un contact à deux échelons avec la face inférieure des plaquettes à circuits imprimés (Lp) et que les poussoirs inférieurs de serrage (Asu) sont déplaçables dans la direction verticale suivant deux échelons.

6. Dispositif de test suivant la revendication 5, caractérisé par le fait que les poussoirs inférieurs de serrage (Asu) sont guidés dans l'adaptateur inférieur à aiguilles (Nau) et peuvent être actionnés par l'intermédiaire d'une plaque de poussée inférieure commune (Dp).

7. Dispositif de test suivant l'une des revendications précédentes, caractérisé en ce que l'adaptateur supérieur à aiguilles (Nao) porte des troisièmes et quatrièmes aiguilles supérieures de contact suspendues élastiquement (Kn3, Kn4), qui sont disposées spécifiquement en fonction de l'échantillon et possèdent des longueurs différentes de manière à permettre un contact à deux échelons avec les faces supérieures des plaquettes à circuits imprimés (Lp).

8. Dispositif de test suivant l'une des revendications précédentes, caractérisé par le fait que pour le positionnement des plaquettes à circuits imprimés (Lp), au moins deux broches de centrage (Zs), qui précèdent les poussoirs supérieurs de serrage (Aso), sont disposées dans l'adaptateur supérieur à aiguilles (Nao).

FIG 1

FIG 2

7

# FIG 3